Europäisches Patentamt

(19) European Patent Office

Office européen des brevets

(11) Publication number: **0 032 812**
**B1**

# EUROPEAN PATENT SPECIFICATION

(45) Date of publication of patent specification: **14.03.84**

(51) Int. Cl.³: **C 22 C 19/05, C 30 B 21/02**

(21) Application number: **81300158.3**

(22) Date of filing: **14.01.81**

(54) Nickel base alloy and turbine engine blade cast therefrom.

(30) Priority: **17.01.80 US 113037**

(43) Date of publication of application:
**29.07.81 Bulletin 81/30**

(45) Publication of the grant of the patent:
**14.03.84 Bulletin 84/11**

(84) Designated Contracting States:
**BE DE FR GB IT**

(56) References cited:
**FR - A - 2 118 621**
**FR - A - 2 216 361**
**FR - A - 2 374 427**
**US - A - 3 526 499**
**US - A - 3 677 747**

(73) Proprietor: CANNON-MUSKEGON CORPORATION
**2875 Lincoln**
**Muskegon Michigan (US)**

(72) Inventor: **Harris, Kenneth**
**18864 Fruitport Road**
**Spring Lake Michigan (US)**

(74) Representative: **Robinson, Anthony John Metcalf**
**et al,**
**Kilburn & Strode 30 John Street**
**London, WC1N 2DD (GB)**

Courier Press, Leamington Spa, England.

Nickel base alloy and turbine engine blade cast therefrom

This invention is in the field of nickel-base casting alloys particularly intended for vacuum casting, by directional solidification, of thin wall products of complex shape for use under extremely demanding service conditions. Particularly are alloys in accordance with this invention suitable to use in the casting of turbine blades (including vanes) for jet engines where the castings will be subjected to extended periods of operation under very high temperatures. For some time equiaxed grain castings were used for such parts. However, these proved unsatisfactory as the operating conditions for the castings became more severe. In response to these problems the gas turbine industry developed the technique of directional solidification (referred to as DS) with significant improvement in high temperature alloy properties and blade performance. However, parts cast by this technique are susceptible to grain boundary cracking.

Designs to increase the power and efficiency of gas turbine engines have required reduction of the wall section of such turbine blade castings to improve blade cooling efficiency. This necessitates the use of special, high strength, cast alloys. Extremely thin wall sections are required to provide rapid thermal transfer because the blades may be operating in a gaseous environment at temperatures above the melting point of the alloy. In such an environment it is critical to provide sufficiently rapid heat transfer to ensure that the actual temperature of the blades is kept below that at which they lose structural integrity. As the wall thickness of the blades has been decreased, the strength of the alloys has had to be increased. However, as the strength of the alloy has been increased, the problem of grain boundary cracking during DS casting of the blades has also increased. The response to this has been the development of improved alloys such as those described in United States Patents 3 526 499, 3 677 747 and 3 720 509. Despite these improvements in ultra high strength alloys suitable for directional solidification, grain boundary cracking has continued to be a problem.

According to the present invention, there is provided nickel base alloy for vacuum directional solidification casting of thin wall, complex cored, high core-to-metal volume ratio castings for use under high stress, high temperature conditions, characterized by the absence of grain boundary cracking, consisting of the following elements in percentages by weight (other than those expressed as ppm):

| | |
|---|---|
| C | .07—.09 |
| Si | .03 max. |
| Mn | .10 max. |
| P | .005 max. |
| S | 20 ppm max. |
| Cr | 7.5—8.5 |
| Co | 9.0—9.5 |
| Mo | 0.4—0.6 |
| W | 9.3—9.7 |
| Ti | 0.6—0.9 |
| Al | 5.4—5.7 |
| Ta | 3.1—3.3 |
| Hf | 1.4—1.6 |
| B | 0.01—0.02 |
| Zr | .007—.015 |
| Fe | .2 max. |
| Cu | .05 max. |
| Nb | .10 max. |
| Mg | 40 ppm max. |
| Pb | 2 ppm max. |
| Se | 1.0 ppm max. |
| Bi | .3 ppm max. |
| Te | .5 ppm max. |
| Tl | .5 ppm max. |
| Ni+incidental impurities | Balance |

After a long period of investigation and experimentation, it has been learned that by reducing the maximum amount of carbon, zirconium, tungsten and molybdenum, the problem of grain boundary cracking can be significantly reduced or eliminated, without significant sacrifice of strength while at the same time substantially eliminating the formation of acicular $M_6C$ under subsequent operating conditions. Acicular phase formation in cast turbine blades is undesirable since it acts as a nucleant for forming premature cracks due to complex fatigue/creep interactions.

The problem of grain boundary cracking has been particularly evident in the thin wall, first stage turbine blade and vane designs for advanced turbine engines. The blades have a wall thickness of 0.635—0.762 mm (0.025—0.030 inches) with very complex coring and a high core-to-metal volume ratio. This type of casting requires a very high strength alloy. This type of casting has been impractical to manufacture from some existing alloys with the required high temperature strength because of potential failure resulting from grain boundary cracking, occurring during the DS casting of the parts. This is a very serious problem in high performance turbine blades and vanes. The operation conditions are such that structural failure is intolerable. Thus, complete and thorough inspection of each part is required. Because of the intricacy of the designs and the minuteness of the passages, these parts can only be inspected internally by suitable probes inserted through each passage and even then the inspector is frequently required to exercise a high degree of judgement as to whether what is seen through the probe is in fact a crack. This is very time consuming and expensive, especially when reject rates involve a substantial percentage of the total castings poured.

It is another important facet of this invention that the alloy remain metallurgically stable under the severe temperature of its operating environment. The fact that alloys in accordance with the present invention are stable and will develop minimum, if any, acicular $M_6C$ is shown by their chemistry and their low $\bar{N}_{v3B}$ value. In these alloys the M is mainly W and Mo. While the presence of W and Mo increases the tendency to formation of the acicular $M_6C$ phase, these elements along with Ta cannot be eliminated because of their essential role in strengthening at high temperatures. The low value for $\bar{N}_{v3B}$ is indicative that no deleterious sigma phase formation will occur. The reduction in C is important in accomplishing the minimized $M_6C$ acicular phase formation by reducing the initial as-cast formation of interdendritic and grain boundary MC (Hf, Ta, Ti) carbides. The fact that the amount of C could be reduced while improving alloy characteristics is significant because C, while essential to the formation of interdendritic and grain boundary carbides, is essential to the strength and stability of the alloy. In the development of these alloys, it was discovered that Zr, a known source of increased alloy creep strength, was also a causative of grain boundary crack sensitivity, although the reason for this is not fully understood. It is known that Zr migrates to the grain boundaries in these cast Nickel-base alloys. Even very minor changes in the percentage of Zr present were found to produce significant changes in alloy DS castability. It is also important to keep the S at extremely low levels (<20 parts per million (ppm)). S migrates to the grain boundary and causes a significant reduction in grain boundary strength and ductility.

Alloys in accordance with this invention not only exhibit virtual or total elimination of the grain boundary cracking problem without unacceptable sacrifice of high temperature strength, but also have dependable repeatability under commercially acceptable manufacturing and foundry use conditions.

A specific composition for the alloy of this invention is tabulated in Column A of Table I. In this tabulation it is compared with a commercially used alloy utilizing the teachings of U.S. Patent 3 720 509, set out in Column B:

TABLE I

|    | A | B |
|----|----|----|
| C | .08 | .13—.17 |
| Si | .03 max. | .15 max. |
| Mn | .10 max. | .20 |
| P | .005 max. | .015 max. |
| S | 20 ppm max. | 100 ppm max. |
| Cr | 8.0 | 8.00—8.80 |
| Co | 9.3 | 9.00—11.00 |
| Mo | .55 | .50—.80 |
| W | 9.5 | 9.50—10.50 |
| Ti | .7 | .90—1.20 |
| Al | 5.60 | 5.30—5.70 |
| Ta | 3.2 | 2.80—3.30 |
| Hf | 1.5 | 1.20—1.60 |
| B | .015 | .010—.020 |
| Zr | .01 | .03—.08 |
| Fe | .2 max. | .25 max. |
| Cu | .05 max. | .10 max. |
| Nb | .10 max. | .10 max. |
| Mg | 40 ppm max. | Not Recorded |
| Pb | 2 ppm max. | 5 ppm max. |
| Se | 1.0 ppm max. | 1 ppm max. |
| Bi | .3 ppm max. | .3 ppm max. |
| Te | .5 ppm max. | .5 ppm max. |
| Tl | .5 ppm max. | .5 ppm max. |
| (N) ppm | 15 max. | Not Recorded |
| (O) ppm | 10 max. | Not Recorded |
| $\bar{N}_{v3B}$ | 2.15 max. | Not Recorded |
| Ni | Balance | Balance |

Many alloys can be formulated in accordance with the invention but some specific examples will now be described. These alloys have been cast in the test device shown in the accompanying drawings, in which:

Figure 1 is a partially schematic, sectional elevational view of the test device for determining susceptibility to grain boundary cracking;

Figure 2 is a sectional view taken along the plane II—II of Figure 1; and

Figure 3 is a photograph of a pair of castings made using the test device of Figures 1 and 2.

Example I

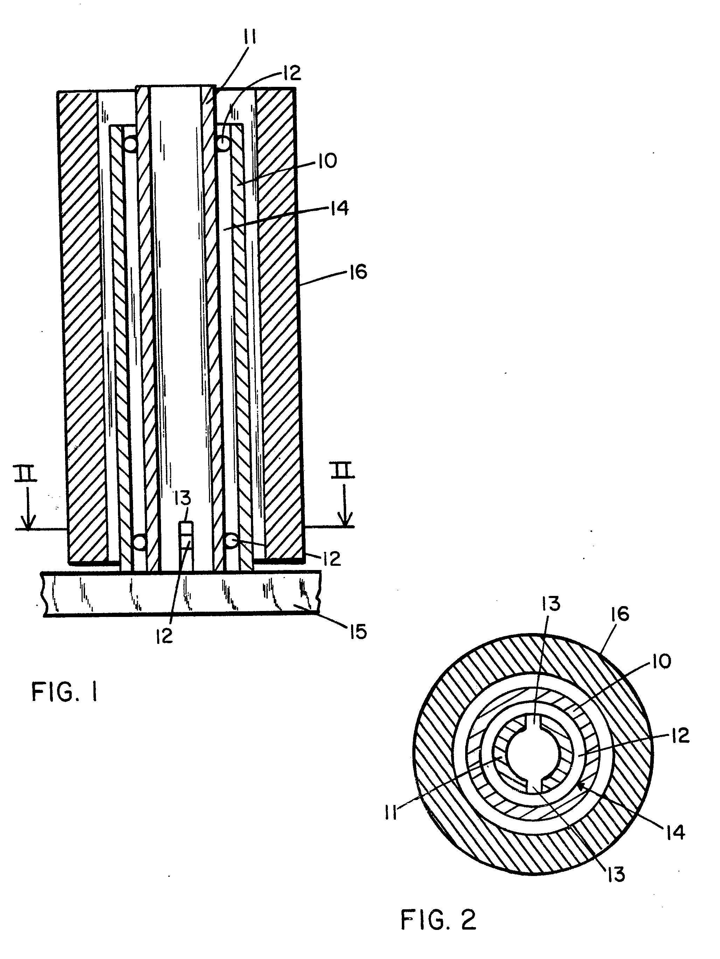

A 113.4 kg (250 pound) heat No. VF-165 utilizing the Column A composition of Table I was manufactured by vacuum induction melting and was tested by vacuum DS casting it has a tube around an alumina core. The equipment for the test is illustrated in Figures 1 and 2.

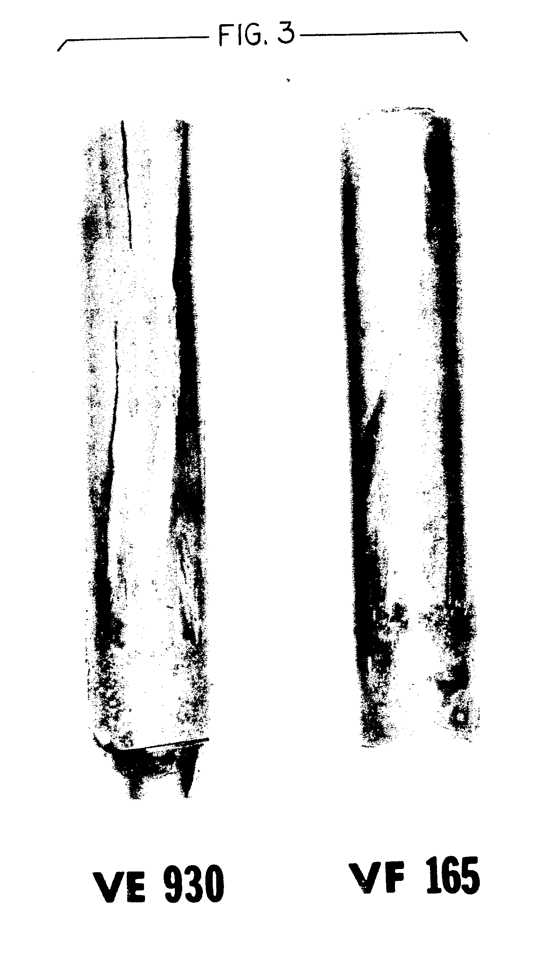

This equipment includes an outer mould shell 10 and an inner tubular mould shell 11 of alumina. The shells were spaced apart at top and bottom and held in concentric relationship by spacer rings 12. Communication is provided between the interior of the inner shell and the annular space between the shells by a pair of vertical channels 13 at the bottom of the inner shell. In this particular test the radial spacing between the shells 10 and 11 forming the annular channel 14 was 0.15 mm and the outside diameter of the shell 11 was 1.9 mm. The test unit was placed on a chill plate 15. The unit was surrounded by an induction heater 16. A rod of the alloy from heat VF-165 was placed within the inner shell 11. The induction heater was turned on to melt the alloy causing it to flow through the channels 13 into the annular space 14. After the annular channel was filled, the induction heater, while still activated, was gradually withdrawn upwardly. This procedure results in directional solidification of the alloy except at the bottom adjacent the chill plate where some equiaxe solidification occurs. This can be seen in the photographs of Figure 3.

Using the identical test equipment and procedure, a second tubular casting was made utilizing the alloy of the composition of Column B from heat No. VE-930.

The castings, after solidification and cooling to room temperature and removal of the outer mould shell were inspected for evidence of cracks. As clearly appears on the left hand side of Figure 3, numerous longitudinal cracks resulting from grain boundary cracking were observed in the casting made from the alloy set out in Column B of Table I. This cracking was observed to have occurred along grain boundary lines entirely around the test casting. In contrast to this, the casting poured from the alloy composition of Column A of Table I showed no evidence of any cracking except some of about 0.5 mm in length at the extreme upper end and some in the equiaxe zone where little or no directional solidification occurred because of the effect of the chill plate 15.

This test is a particularly severe one for alloys susceptible to grain boundary cracking since it develops about a 2% plastic strain. Based upon a rating of A to F wherein:

A   —no cracks apparent
B   —only minor cracks at tips
C to E   —progressively increasing severity of grain boundary cracking
F   —gross grain boundary cracking

the test casting from heat VF-165 (Column A, Table I) was rated A—B.

Example II

Approximately 20 directionally solidified, complex cored, thin wall blades (hereinafter referred to as blades C) were vacuum cast from the alloy of the same heat (VF-165) as that tested in Example I. These were cast using a European-developed, directional solidification, casting process. Identical blades (hereinafter referred to as blades D) were cast from heats V-5134 and V-5224 of the alloy set out in Column B of Table I, except for the following differences:

| | |
|---|---|
| Si | .10 max. |
| Mn | .10 max. |
| P | .010 max. |
| S | 20 ppm max. |
| Mg | 40 ppm max. |
| Pb | 2 ppm max. |
| N ppm | 15 max. |
| O ppm | 10 max. |

The blades cast from both alloys were aged by heat treating at 1600°F. for 20 hours. From the blades of both castings, test specimens of 2.26 mm (0.089 inches) diameter were machine cut and tested for stress-rupture with the following results:

| Longitudinal | Blades C Life hours | Mean life | Heat no. |
|---|---|---|---|
| 500 Mpa/850°C (72.5 ksi/1560°F) | 103, 100, 102 | (Mean 102) | VF-165 |
| 145 MPa/1040°C (21.0 ksi/1900°F) | 42, 44, 49 | (Mean 45) | VF-165 |

| Longitudinal | Blades D Life hours | Mean life | Heat no. |
|---|---|---|---|
| 500 MPa/850°C (72.5 ksi/1560°F) | 134, 143, 155 | (Mean 144) | V-5134 |
| | 115, 128, 120 | (Mean 121) | V-5224 |
| 145 MPa/850°C (21.0 ksi/1900°F) | 53, 55, 64 | (Mean 57) | V-5134 |
| | 47, 48, 55 | (Mean 50) | V-5224 |
| Transverse | | | |
| 465 MPa/850°C (67.5 ksi/1560°F) | 130, 138 | (Mean 134) | V-5134 V-5224 |
| 108 MPa/1040°C (15.7 ksi/1900°F) | 142, 189 | (Mean 165) | V-5134 V-5224 |

| Blade | Tensile properties Temp. | MPa (ksi) | % Elongation |
|---|---|---|---|
| C | 649°C. (1200°F) | 917 (133) | 11.5 |
| D | 649°C. (1200°F) | 855 (124) | 6.4 |
| C | 749°C. (1380°F) | 1000 (145) | 8.1 |
| D | 749°C. (1380°F) | 938 (136) | 5.5 |
| C | 849°C. (1560°F) | 869 (126) | 10.5 |
| D | 849°C. (1560°F) | 862 (125) | 6.9 |

In the case of all of these tests from which this data was compiled the test continued until failure by rupture occurred.

Careful examination of the blades C, including X-ray and fluorescent dye penetrant inspection, revealed no cracks in any of the blades. This is despite the fact that these blades were of a design considered to be "crack prone". These tests indicate that the alloy has overcome the problem of grain boundary cracking with improved tensile properties while retaining acceptable stress rupture properties.

The blades also were cut up and microscopically inspected for microporosity. The blades were found to have internal microporosity of <0.2% with most of the fields exhibiting a microporosity of about 0.1%. These performance capability results for the alloy of Column A are at least equal to those for the alloy of Column B while almost entirely eliminating part rejection because of grain boundary cracking and represent a substantial improvement over other conventional alloys which have been used for casting of high performance turbine blades.

## Claims

1. A nickel base alloy for vacuum directional solidification casting of thin wall, complex cored, high core-to-metal volume ratio castings for use under high stress, high temperature conditions, characterized by the absence of grain boundary cracking, consisting of the following elements in percentages by weight (other than those expressed as ppm).

| | |
|---|---|
| C | .07—.09 |
| Si | .03 max. |
| Mn | .10 max. |
| P | .005 max. |
| S | 20 ppm max. |
| Cr | 7.5—8.5 |
| Co | 9.0—9.5 |
| Mo | 0.4—0.6 |
| W | 9.3—9.7 |
| Ti | 0.6—0.9 |
| Al | 5.4—5.7 |
| Ta | 3.1—3.3 |
| Hf | 1.4—1.6 |
| B | 0.01—0.02 |
| Zr | .007—.015 |
| Fe | .2 max. |
| Cu | .05 max. |
| Nb | .10 max. |
| Mg | 40 ppm max. |
| Pb | 2 ppm max. |
| Se | 1.0 ppm max. |
| Bi | .3 ppm max. |
| Te | .5 ppm max. |
| Tl | .5 ppm max. |
| Ni+incidental impurities | Balance |

2. An alloy as claimed in Claim 1 in which the following elements are present in the weight percentages specified:

| | |
|---|---|
| C | .08 |
| Cr | 8.0 |
| Co | 9.3 |
| Mo | .55 |
| W | 9.5 |
| Ti | .7 |
| Al | 5.60 |
| Ta | 3.2 |
| Hf | 1.5 |
| B | .015 |
| Zr | .01 |

3. An alloy as claimed in Claim 1 or Claim 2 in which the metallurgical stability factor of the alloy expressed by the formula $\bar{N}_{v3B}$ is 2.15 max.

4. An alloy as claimed in Claim 1 or Claim 2 or Claim 3 in which the maximum of each of the elements nitrogen and oxygen is 15 parts per million and 10 parts per million, respectively.

5. An alloy as claimed in any of the preceding claims having a mean longitudinal machined-from-blade (MFB) stress-rupture life of 45 hours at 1040°C. (1900°F) under an applied load of 145 MPa (21.0 ksi).

6. An alloy as claimed in any of the preceding claims having a mean longitudinal MFB stress-rupture life of 102 hours at 850°C. (1560°F) under an applied load of 500 MPa (72.5 ksi).

7. A turbine engine blade of an alloy according to any of the preceding claims cast under vacuum and directionally solidified.

## Revendications

1. Alliage à base de nickel pour la coulée sous vide avec solidification directionnelle de pièces coulées à paroi mince, à cavité complexe, présentant un rapport volumique élevé de la cavité au métal, à utiliser dans des conditions de contrainte élevée et de haute température, caractérisé par l'absence de fissurations aux joints de grains et consistant en les éléments suivants en pourcentages pondéraux (autres que ceux exprimés en ppm):

| | |
|---|---|
| C | 0,07—0,09 |
| Si | 0,03 max. |
| Mn | 0,10 max. |
| P | 0,005 max. |
| S | 20 ppm max. |
| Cr | 7,5—8,5 |
| Co | 9,0—9,5 |
| Mo | 0,4—0,6 |
| W | 9,3—9,7 |
| Ti | 0,6—0,9 |
| Al | 5,4—5,7 |
| Ta | 3,1—3,3 |
| Hf | 1,4—1,6 |
| B | 0,01—0,02 |
| Zr | 0,007—0,015 |
| Fe | 0,2 max. |
| Cu | 0,05 max. |
| Nb | 0,10 max. |
| Mg | 40 ppm max. |
| Pb | 2 ppm max. |

Se 1,0 ppm max.
Bi 0,3 ppm max.
Te 0,5 ppm max.
Ti 0,5 ppm max.
Ni+impuretés accidentelles reste

2. Alliage suivant la revendication 1, dans lequel les éléments suivants sont présents en les pourcentages pondéraux spécifiés:

| | |
|---|---|
| C | 0,08 |
| Cr | 8,0 |
| Co | 9,3 |
| Mo | 0,55 |
| W | 9,5 |
| Ti | 0,7 |
| Al | 5,60 |
| Ta | 3,2 |
| Hf | 1,5 |
| B | 0,015 |
| Zr | 0,01 |

3. Alliage suivant la revendication 1 ou 2, dans lequel le facteur de stabilité métallurgique de l'alliage exprimé par la formule $\overline{N}_{v3B}$ est de 2,15 max.

4. Alliage suivant la revendication 1, 2 ou 3, dans lequel le maximum de chacun des éléments azote et oxygène est de 15 parties par million et de 10 parties par million, respectivement.

5. Alliage suivant l'une quelconque des revendications précédentes ayant une vie moyenne jusqu'à rupture par contrainte longitudinale sur éprouvette usinée dans une ailette de 45 heures à 1040°C (1900°F) sous une charge appliquée de 145 MPa (21.000 livres/pouce²).

6. Alliage suivant l'une quelconque des revendications précédentes ayant une vie moyenne jusqu'à rupture par contrainte longitudinale sur éprouvette usinée dans une ailette de 102 heures à 850°C (1560°F) sous une charge appliquée de 500 MPa (72.500 livres/pouce²).

7. Ailette de turbine faite d'un alliage suivant l'une quelconque des revendications précédentes coulé sous vide et solidifié directionnellement.

## Patentansprüche

1. Nickellegierung für das Gießen von dünnwandigen Gußstücken mit komplexem Kern und großem Verhältnis zwischen Kern- und Metallvolumen unter Vakuum mit gerichteter Erstarrung bzw. Verfestigung, wobei die Gußstücke zur Verwendung bei hoher mechanischer und thermischer Beanspruchung bestimmt sind, gekennzeichnet durch das Fehlen von Korngrenzen-Rißbildung und die folgende Zusammensetzung in Prozent der Legierungselemente (soweit nicht durch ppm—Anteile pro Million gekennzeichnet):

| | |
|---|---|
| C | 0,07—0,09 |
| Si | 0,03 max. |
| Mn | 0,10 max. |
| P | 0,005 max. |
| S | 20 ppm max. |
| Cr | 7,5—8,5 |
| Co | 9,0—9,5 |
| Mo | 0,4—0,6 |
| W | 9,3—9,7 |
| Ti | 0,6—0,9 |
| Al | 5,4—5,7 |
| Ta | 3,1—3,3 |
| Hf | 1,4—1,6 |
| B | 0,01—0,02 |
| Zr | 0,007—0,015 |
| Fe | 0,2 max. |
| Cu | 0,05 max. |
| Nb | 0,10 max. |
| Mg | 40 ppm max. |
| Pb | 2 ppm max. |
| Se | 1,0 ppm max. |
| Bi | 0,3 ppm max. |
| Te | 0,5 ppm max. |
| Tl | 0,5 ppm max. |
| Ni+Verunreinigungen | Rest |

2. Legierung nach Anspruch 1, welche die folgenden Elemente jeweils in den angegebenen Gewichts-Prozenten enthält:

| | |
|---|---|
| C | 0,08 |
| Cr | 8,0 |
| Co | 9,3 |
| Mo | 0,55 |
| W | 9,5 |
| Ti | 0,7 |
| Al | 5,60 |
| Ta | 3,2 |
| Hf | 1,5 |
| B | 0,015 |
| Zr | 0,01 |

3. Legierung nach Anspruch 1 oder 2, bei welcher der metallurgische Stabilitätsfaktor der Legierung, ausgedrückt durch die Formel $\overline{N}_{v3B}$ maximal 2,15 beträgt.

4. Legierung nach Anspruch 1, 2 oder 3, dadurch gekennzeichnet, daß die maximalen Anteile an Stickstoff bzw. Sauerstoff 15 ppm bzw. 10 ppm betragen.

5. Legierung nach einem der vorangehenden Ansprüche, die eine mittlere Lebensdauer bis zum Beanspruchungsbruch einer aus einem blattförmigen Gußstück herausgearbeiteten Probe unter einer Längsbelastung von 145 MPa (21,0 ksi) von 45 Stunden bei 1040°C (1900°F) aufweist.

6. Legierung nach einem der vorangehenden Ansprüche, die eine mittlere Lebensdauer bis zum Beanspruchungsbruch einer aus einem blattförmigen Gußstück herausgearbeitete Probe unter einer Längsbelastung von 500 MPa (72,5 ksi) von 102 Stunden bei 850°C (1560°F) aufweist.

7. Turbinenschaufel aus einer Legierung nach einem der vorangehenden Ansprüche, die unter Vakuum gegossen und gerichtet erstarrt bzw. verfestigt ist.

FIG. 1

FIG. 2

— FIG. 3 —

VE 930          VF 165